# EUROPÄISCHE PATENTANMELDUNG

(11) **EP 4 679 117 A1**
(43) Veröffentlichungstag der Anmeldung: **14.01.2026**
(21) Anmeldenummer: 25186688.5
(22) Anmeldetag: 01.07.2025
(51) Int. Cl.: G01R 31/54, G01R 31/58, B60L 3/00

(54) **VERFAHREN ZUR ÜBERWACHUNG DER DURCHGÄNGIGKEIT EINES SCHUTZLEITERS EINES LADESYSTEMS FÜR ELEKTROFAHRZEUGE UND LADESYSTEM**

(30) Priorität: 11.07.2024 DE 102024119766
(71) Anmelder: Bender GmbH & Co. KG, 35305 Grünberg (DE)
(72) Erfinder: Morich, Lars, 65604 Elz (DE)
(74) Vertreter: advotec.

(57) **Zusammenfassung**

Die Erfindung betrifft ein Verfahren zur Überwachung der Durchgängigkeit eines Schutzleiters (PE) eines gemäß der Norm IEC 61851-1 ausgeführten konduktiven Ladesystems (2) für Elektrofahrzeuge (4), wobei das Ladesystem (2) eine Ladestation (6) mit einem CP-Generator (8) zur Erzeugung eines CP-Steuersignals (10) sowie ein Ladekabel (12) umfasst, welches den Schutzleiter (PE), aktive Leiter (N, L1, L2, L3), einen CP-Signalleiter (CP) und einen PP-Signalkontakt (PP) aufweist. Das erfindungsgemäße Verfahren umfasst die Verfahrensschritte Erfassen und Auswerten eines in den aktiven Leitern N, L1, L2, L3 fließenden Differenzstroms (14) mittels eines allstromsensitiven Differenzstrom-Überwachungsmoduls (RCM) in Kombination mit einem Messstromwandler (16), wobei durch Erfassen und Auswerten des von dem CP-Generator (8) erzeugten CP-Steuersignals (10) in dem Differenzstrom (14) eine Unterbrechung (18) des Schutzleiters (PE) festgestellt wird.

Weiterhin betrifft die Erfindung ein auf der Norm IEC 61851-1 beruhendes, erfindungsgemäßes konduktives Ladesystem für Elektrofahrzeuge, welches das erfindungsgemäße Verfahren umsetzt.

## Beschreibung

Die Erfindung betrifft ein Verfahren zur Überwachung der Durchgängigkeit eines Schutzleiters eines gemäß der Norm IEC 61851-1 ausgeführten konduktiven Ladesystems für Elektrofahrzeuge, wobei das Ladesystem eine Ladestation mit einem CP-Generator (Control Pilot) zur Erzeugung eines CP-Steuersignals sowie ein Ladekabel umfasst, welches den Schutzleiter (PE - Protective Earth), aktive Leiter, eine CP-Signalleitung und einen PP-Signalkontakt (Proximity Pilot) aufweist.

Des Weiteren betrifft die Erfindung ein gemäß der Norm IEC 61851-1 ausgeführtes konduktives Ladesystem für Elektrofahrzeuge, welches für die Durchführung des erfindungsgemäßen Verfahrens zur Überwachung der Durchgängigkeit eines Schutzleiters ausgelegt ist.

Die Norm IEC 61851-1 gilt für Ladesysteme zum kabelgebundenen Laden von Elektrofahrzeugen und beschreibt unter anderem die Eigenschaften und Betriebsbedingungen der Stromversorgungseinrichtungen und des Anschlusses an das Elektrofahrzeug. Insbesondere ist auch die ständige Überwachung der Durchgängigkeit des Schutzleiters zu dem Elektrofahrzeug vorgeschrieben.

In dieser Systemnorm werden unterschiedliche Ladebetriebsarten definiert. In Verbindung mit einer festinstallierten Ladestation wird vorrangig die Ladebetriebsart 3 für das einphasige und dreiphasige Laden mit Wechselstrom genutzt. Die Steuerung des Ladevorgangs sowie die Sicherheitsfunktionalität und der Kommunikationsablauf zwischen Ladestation und Elektrofahrzeug sind in der Ladestation integriert und werden dort als Funktionseinheiten vorzugsweise von einem Laderegler ausgeführt. Das Ladekabel und der zugehörige Typ-2-Stecker weisen normgemäß vier stromführende (aktive) Leiter/Kontakte - drei Außenleiter L1, L2, L3 und den Neutralleiter N - sowie den Schutzleiter, die CP-Signalleitung und den PP-Signalkontakt auf.

Die Kommunikation zwischen der Ladestation und dem Elektrofahrzeug erfolgt über die CP-Signalleitung. Dabei wird bei angeschlossenem Elektrofahrzeug von dem CP-Generator in der Ladestation das CP-Steuersignal in Form eines Rechtecksignals mit einer 1 kHz Grundfrequenz erzeugt und auf die CP-Signalleitung gelegt. Über eine Pulsweitenmodulation (PWM-Signalisierung/Codierung) des Rechtecksignals wird dem Elektrofahrzeug der von der Ladestation maximal verfügbare Ladestrom mitgeteilt.

Das von der Ladestation über den CP-Signalleiter an das Elektrofahrzeug gesendete CP-Steuersignal wird bei angeschlossenem Elektrofahrzeug über den Schutzleiter des Ladekabels zurückgeführt. Der Laderegler in der Ladestation kann somit durch eine Spannungsmessung an dem CP-Signalleiter gegen Erde (Schutzleiter) erkennen, dass ein Elektrofahrzeug mit der Ladestation verbunden ist, da sich bei angeschlossenem Elektrofahrzeug ein Stromkreis ausbildet, in dem ein Strom fließt, dessen Größe durch die fahrzeugseitige Aufschaltung unterschiedlicher Widerstände bestimmt wird. Da der Schutzleiter als Rückleiter für das CP-Steuersignal dient, kann damit zugleich die Durchgängigkeit des Schutzleiters überwacht werden.

Das CP-Steuersignal und damit die ladestationsseitig an dem CP-Signalleiter gegen den Schutzleiter ermittelten Messspannungen weisen unterschiedliche Signalformen mit unterschiedlichen Amplituden auf (konstante oder PWM-modulierte Signalverläufe), wobei jedem Kurvenverlauf ein Ladezustand (Grundstatus) A bis F zugeordnet ist. So zeigt eine gemessene, konstante Leerlaufspannung an, dass kein Elektrofahrzeug mit der Ladestation verbunden ist (Ladezustand A). Wird ein Elektrofahrzeug angeschlossen, so geht der CP-Generator in den Ladezustand B mit PWM-moduliertem Rechtecksignal und reduzierter Amplitude als CP-Steuersignal über. Bei ladebereitem Elektrofahrzeug folgt der Ladezustand C mit weiter reduzierter Amplitude des PWM-modulierten Rechtecksignals. Die weiteren Ladezustände D bis F beschreiben bestimmte Betriebs- oder Fehlerzustände. Bei einer Statusänderung in den Ladezustand A oder Ladezustand B wird das Elektrofahrzeug innerhalb von 100 ms von der Ladestation getrennt.

Allerdings kann der jeweilige Status oder eine Statusänderung von der Ladestation nicht sicher erkannt werden, wenn als Rückleiter für das CP-Steuersignal eine andere leitfähige Verbindung als der Schutzleiter auftritt. Insbesondere steht bei einer Unterbrechung des Schutzleiters dieser nicht als Rückleiter des CP-Steuersignals zur Verfügung.

Der vorliegenden Erfindung liegt somit die Aufgabe zugrunde, ein weiteres Verfahren zur Überwachung der Durchgängigkeit des Schutzleiters sowie ein dieses Verfahren umsetzendes Ladesystem zu konzipieren, mit denen eine Unterbrechung des Schutzleiters festgestellt werden kann.

Diese Aufgabe wird in Verbindung mit den Merkmalen des Oberbegriffs in Anspruch 1 dadurch gelöst, dass durch Erfassen und Auswerten des von dem CP-Generator erzeugten CP-Steuersignals in dem Differenzstrom eine Unterbrechung des Schutzleiters festgestellt wird.

Die grundlegende Idee des erfindungsgemäßen Verfahrens beruht somit darauf, dass, falls das CP-Steuersignal in Folge eines Defekts des Schutzleiters nicht über diesen zurückgeführt werden kann, ein von dem CP-Generator getriebener Strom im Normalfall nur über die aktiven Leiter von dem Elektrofahrzeug zu der Ladestation zurückfließen kann. Der von dem allstromsensitiven Differenzstrom-Überwachungsmodul in Kombination mit einem die aktiven Leiter umschließenden Messstromwandler erfasste Differenzstrom wird nun daraufhin ausgewertet, ob darin ein von dem CP-Generator erzeugtes CP-Steuersignal als Differenzstromanteil enthalten ist. Wird ein CP-Steuersignal in dem Differenzstrom erkannt, so gilt eine Unterbrechung des Schutzleiters als festgestellt. Bei einer durchgängigen (intakten) Schutzleiterverbindung wird in dem über die aktiven Leiter erfassten Differenzstrom kein CP-Steuersignal zu erkennen sein.

In weiterer vorteilhafter Ausgestaltung wird dem Differenzstrom-Überwachungsmodul das Senden des in dem CP-Generator erzeugten PWM-modulierten Rechtecksignals über eine Sendestatus-Signalleitung signalisiert.

Das Anlegen des in der Norm IEC 61851-1 als CP-Steuersignal definierten 1 kHz Rechtecksignals an den CP-Signalleiter wird dem Differenzstrom-Überwachungsmodul über eine Sendestatus-Signalleitung mitgeteilt. Mit dieser Synchronisation ist dem Differenzstrom-Überwachungsmodul bekannt, in welchem Zeitraum (bei defektem Schutzleiter) ein CP-Steuersignal zu erwarten ist, sodass ein durch Fremdeinflüsse erzeugtes und unerwünscht überlagertes 1 kHz Störsignal nicht zu einer Fehlfunktion führt.

Neben dem Sendestatus (CP-Steuersignal senden/nicht senden) des CP-Generators wird dem Differenzstrom-Überwachungsmodul über die Sendestatus-Signalleitung auch das Tastverhältnis des PWM-modulierten 1 kHz Rechtecksignals mitgeteilt, um in dem Differenzstrom-Überwachungsmodul durch entsprechende Parametereinstellungen eine zuverlässige Erkennung des CP-Steuersignals zu ermöglichen.

Bevorzugt erfolgt das Erkennen und Auswerten des von dem CP-Generator erzeugten CP-Steuersignals in dem erfassten Differenzstrom mittels einer softwarebasierten Erweiterung des Differenzstrom-Überwachungsmoduls.

Das Erkennen und Auswerten des CP-Steuersignals als Teil des erfassten Differenzstroms wird bevorzugt in dem bereits vorhandenen Differenzstrom-Überwachungsmodul ausgeführt. Dazu wird dieses softwarebasiert erweitert, wobei digitale Filterarchitekturen zum Einsatz gelangen, deren Parametrierung unter Nutzung des übermittelten PWM-Tastverhältnisses erfolgt.

Mit Vorteil wird eine von dem Differenzstrom-Überwachungsmodul festgestellte Unterbrechung des Schutzleiters an einen Laderegler der Ladestation mittels eines PE-Statussignals auf einer PE-Statusleitung gemeldet.

Wird von dem Differenzstrom-Überwachungsmodul in dem erfassten Differenzstrom ein CP-Steuersignal in Form des 1 kHz Rechtecksignals erkannt und somit eine Unterbrechung des Schutzleiters festgestellt, so wird diese Unterbrechung des Schutzleiters mittels eines PE-Statussignals auf einer PE-Statusleitung an den Laderegler der Ladestation gemeldet.

Das PE-Statussignal wird in dem Laderegler zur Steuerung des Ladevorgangs ausgewertet.

Der Laderegler kann bei einer festgestellten und mittels des PE-Statussignals signalisierten Unterbrechung des Schutzleiters ein Schütz zur Trennung des Elektrofahrzeugs aktivieren und gegebenenfalls weitere Verfahrensschritte einleiten.

Weiterhin wird die der Erfindung zugrundeliegende Aufgabe durch ein gemäß der Norm IEC 61851-1 ausgeführtes konduktives Ladesystem für Elektrofahrzeuge gelöst, welches das erfindungsgemäße Verfahren umsetzt.

Die mit den beanspruchten strukturellen Merkmalen beschriebenen Funktionseinheiten des erfindungsgemäßen konduktiven Ladesystems führen die entsprechenden Verfahrensschritte des erfindungsgemäßen Verfahrens aus. Somit treffen die mit dem Verfahren erzielten technischen Wirkungen und die daraus resultierenden Vorteile gleichermaßen auch auf das Ladesystem zu.

Insbesondere weist das Ladesystem ein allstromsensitives Differenzstrom-Überwachungsmodul auf, welches zur Erkennung und Auswertung des von dem CP-Generator erzeugten CP-Steuersignals in dem erfassten Differenzstrom ausgelegt ist, um eine Unterbrechung des Schutzleiters festzustellen.

Das mittels einer softwarebasierten Erweiterung ausgeführte Differenzstrom-Überwachungsmodul ist somit in der Lage, das CP-Steuersignal in Form des 1 kHz-Rechtecksignals auf den aktiven Leitern zu detektieren.

Aufgabengemäß wird damit eine weitere, besonders bauteileffiziente Möglichkeit zur Überwachung der Durchgängigkeit des Schutzleiters bereitgestellt.

Weitere vorteilhafte Ausgestaltungsmerkmale ergeben sich aus der nachfolgenden Beschreibung und den Zeichnungen, die eine bevorzugte Ausführungsform der Erfindung anhand von Beispielen erläutern.

Es zeigen:
- **Fig. 1**: ein erfindungsgemäßes konduktives Ladesystem mit intaktem Schutzleiter und
- **Fig. 2**: ein erfindungsgemäßes konduktives Ladesystem bei Unterbrechung des Schutzleiters.

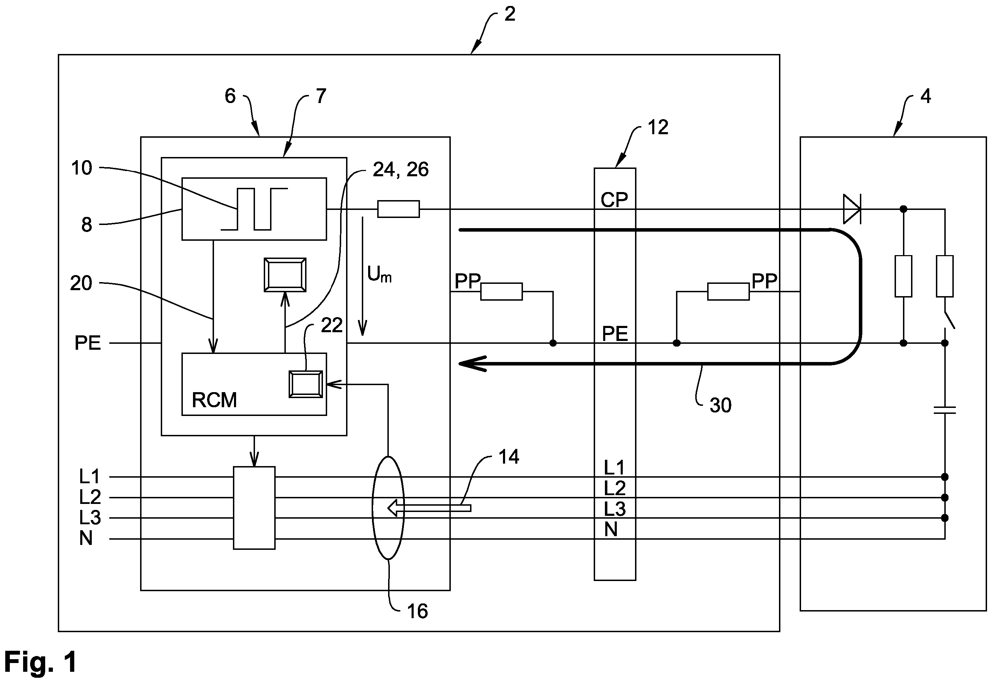

**Fig. 1** zeigt ein nach der Norm IEC 61851-1 ausgeführtes, erfindungsgemäßes konduktives Ladesystem 2 für Elektrofahrzeuge 4 mit intaktem Schutzleiter PE.

Das Ladesystem 2 umfasst eine Ladestation 6 sowie ein Ladekabel 12 mit aktiven Leitern L1, L2, L3, N und dem zu überwachenden Schutzleiter PE sowie mit einem CP-Signalleiter CP und einem PP-Signalkontakt als Steckerkontakt eines normgemäßen Typ-2-Steckers.

Die Ladestation 6 weist einen CP-Generator 8 auf, der ein CP-Steuersignal 10 erzeugt. Mit dem CP-Steuersignal 10 wird der CP-Signalleiter CP beaufschlagt, wobei der Schutzleiter PE als Rückleiter dient. Bei angeschlossenem Elektrofahrzeug 4 bildet sich somit ein Stromkreis 30 aus, der über den CP-Signalleiter CP, einen Dioden-Widerstandszweig in dem Elektrofahrzeug 4 und den Schutzleiter PE führt.

In dem dargestellten Ausführungsbeispiel sind der CP-Generator 8 sowie ein Differenzstrom-Überwachungsmodul RCM Funktionseinheiten eines Ladereglers 7. Das Differenzstrom-Überwachungsmodul RCM ist mit einem die aktiven Leiter L1, L2, L3, N umschließenden Messstromwandler 16 verbunden, der einen Differenzstrom 14 erfasst.

Anhand einer ladestationsseitigen Spannungsmessung (Messspannung Uₘ) zwischen dem CP-Signalleiter CP und dem Schutzleiter PE stellt die Ladestation 6 fest, ob ein Elektrofahrzeug 4 angeschlossen ist. Ist kein Elektrofahrzeug 4 angeschlossen (Ladezustand A), so wird als Messspannung Uₘ eine von dem CP-Generator 8 angelegte Gleichspannung (Leerlaufspannung) gemessen.

Wird das Elektrofahrzeug 4 angeschlossen, so bildet sich aufgrund eines fahrzeugseitig geschalteten Widerstands der Stromkreis 30 aus, wobei ein Absinken der Messspannung Uₘ an dem CP-Signalleiter CP gegen den Schutzleiter PE von der Ladestation 6 erkannt wird (Ladezustand B) und der CP-Generator daraufhin ein PWM-moduliertes 1 kHz Rechtecksignal als CP-Steuersignal 10 auf den CP-Signalleiter CP schaltet.

Ist das Elektrofahrzeug 4 zum Laden bereit, so schaltet dieses einen weiteren (Parallel-)Widerstand zwischen den CP-Signalleiter CP und den Schutzleiter PE, sodass ein entsprechender Spannungsabfall der Messspannung Uₘ von der Ladestation 6 erkannt wird und der Ladestrom freigeschaltet wird. Der momentan verfügbare Ladestrom wird durch eine Pulsweitenmodulation des 1 kHz Rechtecksignals von der Ladestation 6 dem Elektrofahrzeug 4 mitgeteilt.

Eine durchgängige, intakte Schutzleiterverbindung (Schutzleiter PE) ist somit neben der Gewährleistung der elektrischen Sicherheit auch für die Steuerung des Ladevorgangs und für die Kommunikation zwischen der Ladestation 2 und Elektrofahrzeug 4 unerlässlich.

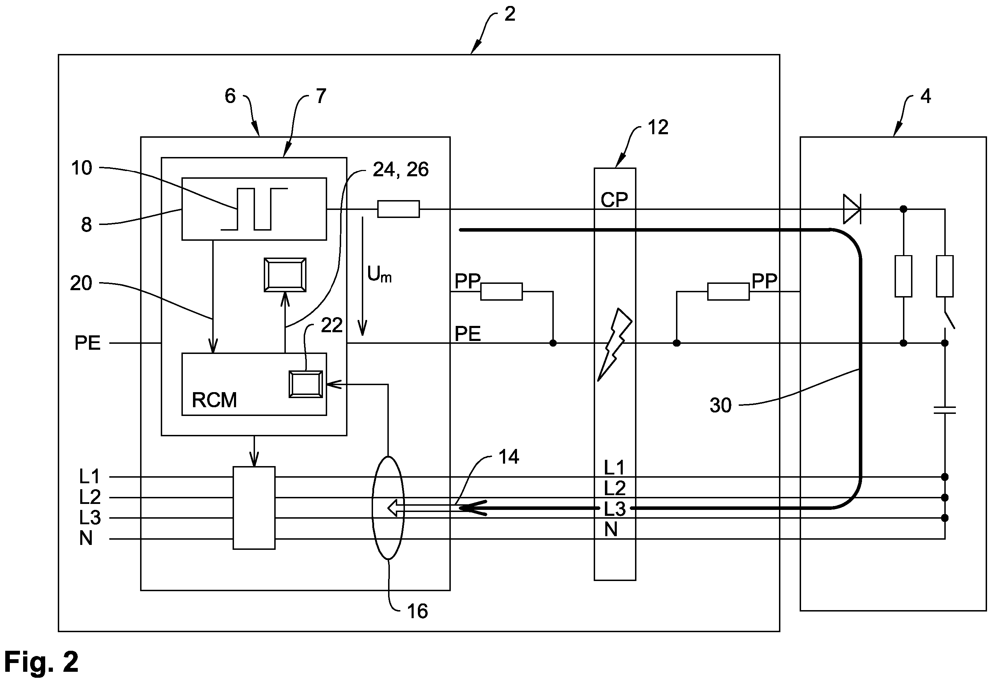

**Fig. 2** zeigt ein nach der Norm IEC 61851-1 ausgeführtes, erfindungsgemäßes konduktives Ladesystem 2 für Elektrofahrzeuge 4 im Falle einer Unterbrechung 18 des Schutzleiters PE.

In diesem Fall kann der durch das CP-Steuersignal 10 bewirkte Strom nicht über den Schutzleiter PE zurückgeführt werden. In der Regel schließt sich der Stromkreis 30 dann über die aktiven Leiter L1, L2, L3, N.

Erfindungsgemäß ist das Differenzstrom-Überwachungsmodul RCM derart ausgelegt, dass ein dem CP-Steuersignal 10 entsprechender Differenzstromverlauf in dem Differenzstrom 14 erkannt und ausgewertet werden kann.

Dazu umfasst das Differenzstrom-Überwachungsmodul RCM eine softwarebasierte Erweiterung 22, welche das 1 kHz Rechtecksignal mittels Verfahren der digitalen Signalverarbeitung (Filterung) detektiert.

Um dem Differenzstrom-Überwachungsmodul RCM mitzuteilen, wann das CP-Steuersignal 10 in der (Signal-)Form des 1 kHz Rechtecksignals gesendet wird und damit bei unterbrochenem Schutzleiter PE auf den aktiven Leitern L1, L2, L3, N zu erwarten ist, wird das Differenzstrom-Überwachungsmodul RCM über eine Datenschnittstelle mit einer Sendestatus-Signalleitung 20 mit dem CP-Generator 8 synchronisiert. Zugleich wird über die Sendestatus-Signalleitung 20 das Tastverhältnis des PWM-modulierten 1 kHz Rechtecksignals zur geeigneten Einstellung der softwarebasierten Filterparameter übermittelt.

Eine von dem Differenzstrom-Überwachungsmodul RCM festgestellte Unterbrechung 18 des Schutzleiters PE wird mittels eines PE-Statussignals 24 über eine Datenschnittstelle mit einer PE-Statusleitung 26 an den Laderegler 7 der Ladestation 6 signalisiert. Der Laderegler 7 ist damit in der Lage, nach Auswertung des PE-Statussignals 24 den Ladestrom freizugeben oder gegebenenfalls die Freigabe zu verweigern.

## Patentansprüche

1. Verfahren zur Überwachung der Durchgängigkeit eines Schutzleiters (PE) eines gemäß der Norm IEC 61851-1 ausgeführten konduktiven Ladesystems (2) für Elektrofahrzeuge (4), wobei das Ladesystem (2) eine Ladestation (6) mit einem CP-Generator (8) zur Erzeugung eines CP-Steuersignals (10) sowie ein Ladekabel (12) umfasst, welches den Schutzleiter (PE), aktive Leiter (N, L1, L2, L3), einen CP-Signalleiter (CP) und einen PP-Signalkontakt (PP) aufweist, umfassend die Verfahrensschritte:
Erfassen und Auswerten eines in den aktiven Leitern N, L1, L2, L3 fließenden Differenzstroms (14) mittels eines allstromsensitiven Differenzstrom-Überwachungsmoduls (RCM) in Kombination mit einem Messstromwandler (16),
**dadurch gekennzeichnet,**
**dass** durch Erfassen und Auswerten des von dem CP-Generator (8) erzeugten CP-Steuersignals (10) in dem Differenzstrom (14) eine Unterbrechung (18) des Schutzleiters (PE) festgestellt wird.

2. Verfahren nach Anspruch 1,
**dadurch gekennzeichnet,**
**dass** dem Differenzstrom-Überwachungsmodul (RCM) das Senden des in dem CP-Generator (8) erzeugten PWM-modulierten Rechtecksignals über eine Sendestatus-Signalleitung (20) signalisiert wird.

3. Verfahren nach Anspruch 1 oder 2,
**dadurch gekennzeichnet,**
**dass** das Erkennen und Auswerten des von dem CP-Generator (8) erzeugten CP-Steuersignals (10) in dem erfassten Differenzstrom (14) mittels einer Software-basierten Erweiterung (22) des Differenzstrom-Überwachungsmoduls (RCM) erfolgt.

4. Verfahren nach einem der Ansprüche 1 bis 3,
**dadurch gekennzeichnet,**
**dass** eine von dem Differenzstrom-Überwachungsmodul (RCM) festgestellte Unterbrechung (18) des Schutzleiters (PE) an einen Laderegler (7) der Ladestation (6) mittels eines PE-Statussignals (24) auf einer PE-Statusleitung (26) gemeldet wird.

5. Verfahren nach Anspruch 4,
**dadurch gekennzeichnet,**
**dass** das PE-Statussignal (24) in dem Laderegler (7) zur Steuerung des Ladevorgangs ausgewertet wird.

6. Gemäß der Norm IEC 61851-1 ausgeführtes konduktives Ladesystem (2) für Elektrofahrzeuge (4), welches ausgelegt zur Überwachung der Durchgängigkeit eines Schutzleiters (PE), wobei das Ladesystem (2) eine Ladestation (6) mit einem CP-Generator (8) zur Erzeugung eines CP-Steuersignals (10) sowie ein Ladekabel (12) umfasst, welches den Schutzleiter (PE), aktive Leiter (N, L1, L2, L3), einen CP-Signalleiter (CP) und einen PP-Signalkontakt (PP) aufweist,
mit einem allstromsensitiven Differenzstrom-Überwachungsmodul (RCM), welches in Kombination mit einem Messstromwandler (16) einen in den aktiven Leitern (N, L1, L2, L3) fließenden Differenzstrom (14) in dem Ladesystem (2) erfasst und auswertet,
**dadurch gekennzeichnet,**
**dass** das Differenzstrom-Überwachungsmodul (RCM) ausgelegt ist zur Erkennung und Auswertung des von dem CP-Generator (8) erzeugten CP-Steuersignals (10) in dem erfassten Differenzstrom (14), um eine Unterbrechung (18) des Schutzleiters (PE) festzustellen.

7. Konduktives Ladesystem (2) für Elektrofahrzeuge (4) nach Anspruch 6, **gekennzeichnet durch**
eine Sendestatus-Signalleitung (20), über die dem Differenzstrom-Überwachungsmodul (RCM) das Senden des in dem CP-Generator (8) erzeugten PWM-modulierten Rechtecksignals signalisiert wird.

8. Konduktives Ladesystem (2) für Elektrofahrzeuge (4) nach Anspruch 6 oder 7,
**dadurch gekennzeichnet,**
**dass** das Differenzstrom-Überwachungsmodul (RCM) eine Softwarebasierte Erweiterung (22) zur Erkennung und Auswertung des von dem CP-Generator (8) erzeugten CP-Steuersignals (10) in dem erfassten Differenzstrom (14) aufweist.

9. Konduktives Ladesystem (2) für Elektrofahrzeuge (4) nach einem der Ansprüche 6 bis 8,
**gekennzeichnet durch**
eine PE-Statusleitung (26), über die eine von dem Differenzstrom-Überwachungsmodul (RCM) festgestellte Unterbrechung (18) des Schutzleiters (PE) mittels eines PE-Statussignals (24) an einen Laderegler (7) der Ladestation (6) gemeldet wird.

10. Konduktives Ladesystem (2) für Elektrofahrzeuge (4) nach Anspruch 9, **dadurch gekennzeichnet,**
**dass** der Laderegler (7) ausgelegt ist zur Auswertung des PE-Statussignals (24), um den Ladevorgang zu steuern.
